Europäisches Patentamt

European Patent Office

Office européen des brevets

(11) Numéro de publication: **0 336 814**

**A1**

## (12) DEMANDE DE BREVET EUROPEEN

(21) Numéro de dépôt: **89400849.9**

(22) Date de dépôt: **24.03.89**

(51) Int. Cl.⁴: **G 01 R 31/26**

(30) Priorité: **01.04.88 FR 8804390**

(43) Date de publication de la demande:
**11.10.89 Bulletin 89/41**

(84) Etats contractants désignés: **DE IT NL**

(71) Demandeur: **THOMSON-CSF**
**51, Esplanade du Général de Gaulle**
**F-92800 Puteaux (FR)**

(72) Inventeur: **Benahim, Guy**
**SCPI CEDEX 67**
**F-92045 Paris la Défense (FR)**

**Giraudon, Jean-Claude**
**SCPI CEDEX 67**
**F-92045 Paris la Défense (FR)**

**Parquet, Thierry**
**SCPI CEDEX 67**
**F-92045 Paris la Défense (FR)**

(74) Mandataire: **Benoit, Monique et al**
**THOMSON-CSF SCPI**
**F-92045 PARIS LA DEFENSE CEDEX 67 (FR)**

(54) Dispositif et procédé de mesure thermique d'un transistor bipolaire en fonctionnement.

㊸ L'invention concerne un dispositif pour mesurer la température atteinte par la jonction d'un transistor bipolaire fonctionnant en amplificateur classe C.

L'invention réside dans le fait que l'on mesure la variation de la tension Vbe du transistor amplificateur (3) à courant constant i en dehors des impulsions à amplifier à l'aide d'un oscilloscope (16). Le courant constant i, qui est fourni par un générateur (17), est aiguillé soit vers le transistor (3) en dehors desdites impulsions, soit vers le transistor FET 13 pendant lesdites impulsions. Comme la mesure de la variation de Vbe est proportionnelle à la variation de la température de la jonction, on peut en déduire la température atteinte par la jonction.

L'invention est applicable aux amplificateurs pour émetteurs radars.

FIG_1

EP 0 336 814 A1

## Description

### DISPOSITIF ET PROCEDE DE MESURE THERMIQUE D'UN TRANSISTOR BIPOLAIRE EN FONCTIONNEMENT

L'invention concerne un dispositif pour mesurer certaines caractéristiques thermiques d'un transistor bipolaire lors de son fonctionnement en classe C.

Les fabricants de transistors fournissent un certain nombre de caractéristiques tels que le gain, la fréquence maximum, la puissance de sortie, la tension d'alimentation, le rendement... des diverses catégories de transistors qu'ils fabriquent. L'une des caractéristiques importantes est l'impédance ou résistance thermique Zth qui est définie comme le rapport (Tj - Ts)/Pd dans lequel :

Tj est la température de jonction du transistor,

Ts est la température du transistor, c'est-à-dire celle du boîtier, et

Pd est la puissance dissipée par le transistor.

Ce rapport, exprimé en °C par watt, permet par exemple de calculer Tj à partir de la connaissance de Ts et Pd, ce paramètre Tj permettant alors d'en déduire, à l'aide de courbes fournies par le fabricant, la durée de vie du transistor.

Or, la valeur Tj, qui est ainsi déterminée est une valeur moyenne et il en résulte que la jonction peut atteindre des températures bien supérieures lorsque le transistor fonctionne en régime impulsionnel, par exemple en classe C. Cette augmentation momentanée de température conduit alors à une durée de vie plus courte.

Il y a donc grand intérêt à connaître la température de jonction du transistor au cours de son fonctionnement. Jusqu'à présent, cette mesure est effectuée en relevant le rayonnement infrarouge du transistor fonctionnant dans les conditions normales d'utilisation. Il est alors nécessaire d'ôter le capot de protection pour recevoir le rayonnement infrarouge des points chauds. On comprend que cette méthode de mesure ne peut être mise en oeuvre qu'au cours de la fabrication avant mise sous capot ou à titre exceptionnel par l'utilisateur car, dans ce dernier cas, le transistor sans capot de protection ne peut plus être monté sur un équipement.

Un but de la présente invention est donc de réaliser un dispositif de mesure de la température de jonction atteinte par un transistor en cours de fonctionnement, notamment en régime impulsionnel.

L'invention se rapporte à un dispositif de mesure de la température de jonction d'un transistor bipolaire fonctionnant en régime dynamique pulsé, caractérisé en ce qu'il comprend :

- un générateur de courant continu pour fournir un courant i de valeur faible vis-à-vis du courant traversant le transistor bipolaire pendant la durée de l'impulsion.

- un circuit de commutation pour aiguiller le courant i vers la jonction base-émetteur du transistor bipolaire en l'absence de ladite impulsion et,

- un circuit de mesure de la variation de tension émetteur-base du transistor en l'absence de ladite impulsion, cette variation de tension étant liée à la variation de température de la jonction base-émetteur, ce qui permet de connaître la température atteinte par la jonction pendant l'impulsion à amplifier.

D'autres caractéristiques et avantages de la présente invention apparaîtront à la lecture de la description suivante d'un exemple particulier de réalisation, ladite description étant faite en relation avec les dessins joints dans lesquels :

- La figure 1 est un schéma de principe d'un amplificateur fonctionnant en classe C auquel est associé un dispositif de mesure thermique selon l'invention,

- la figure 2 est un diagramme montrant la courbe de variation de la tension Veb d'un transistor bipolaire en fonction de la température de la jonction,

- les figures 3.a à 3.f sont des diagrammes d'un certain nombre de signaux significatifs, et

- La figure 4 est un schéma de principe d'un dispositif automatique de mesure de la température de la jonction d'un transistor bipolaire selon l'invention.

Le schéma de principe d'un amplificateur fonctionnant en classe C est montré à l'extérieur d'un rectangle 1 dans lequel est représenté le schéma de principe d'un dispositif de mesure thermique selon l'invention.

L'amplificateur classe C comprend un transistor bipolaire 3 dont la base B est au potentiel de la masse, l'émetteur E est relié à un générateur de signaux à amplifier 14 par l'intermédiaire d'un circuit d'adaptation d'impédance 4 et un condensateur 11. Le collecteur C est connecté à la sortie par un circuit d'adaptation d'impédance 5 et un condensateur 12.

Du point de vue du courant continu, le collecteur C est connecté à la tension d'alimentation Vcc par l'intermédiaire d'un réseau, comprenant une bobine de choc 6 et un condensateur 9, qui ne laisse pas passer le courant haute fréquence. Un condensateur 10 est prévu pour limiter les variations de la tension Vcc pendant le fonctionnement. L'émetteur E est connecté au potentiel de la masse via un réseau, comprenant une bobine de choc 7 et un condensateur 8, qui ne laisse pas passer le courant haute fréquence.

Les signaux impulsionnels à amplifier Se fournis par le générateur 14, sont appliqués entre émetteur et base tandis que les signaux amplifiés Ss sont recueillis entre collecteur et base.

Le dispositif de mesure thermique 1 selon l'invention comprend un transistor à effet de champ 13 dont la source S est connectée au point commun 15 de la bobine 7 et du condensateur 8 tandis que le drain D est connecté au potentiel de masse. La grille G est connectée à un générateur de signaux 2 qui est relié au générateur 14 de manière à recevoir des signaux synchronisés avec l'enveloppe des signaux à amplifier. Le point commun 15 est connecté à un oscilloscope 16 et à un générateur de courant 17 fournissant un courant i.

L'invention est basée sur une propriété connue des transistors bipolaires selon laquelle, pour un courant constant i traversant la jonction base-émetteur, toute variation de température δt de la jonction donne naissance à une variation de tension émetteur-base δVeb selon une loi linéaire qui s'exprime par :

$$\delta Veb = K\delta t \quad (1)$$

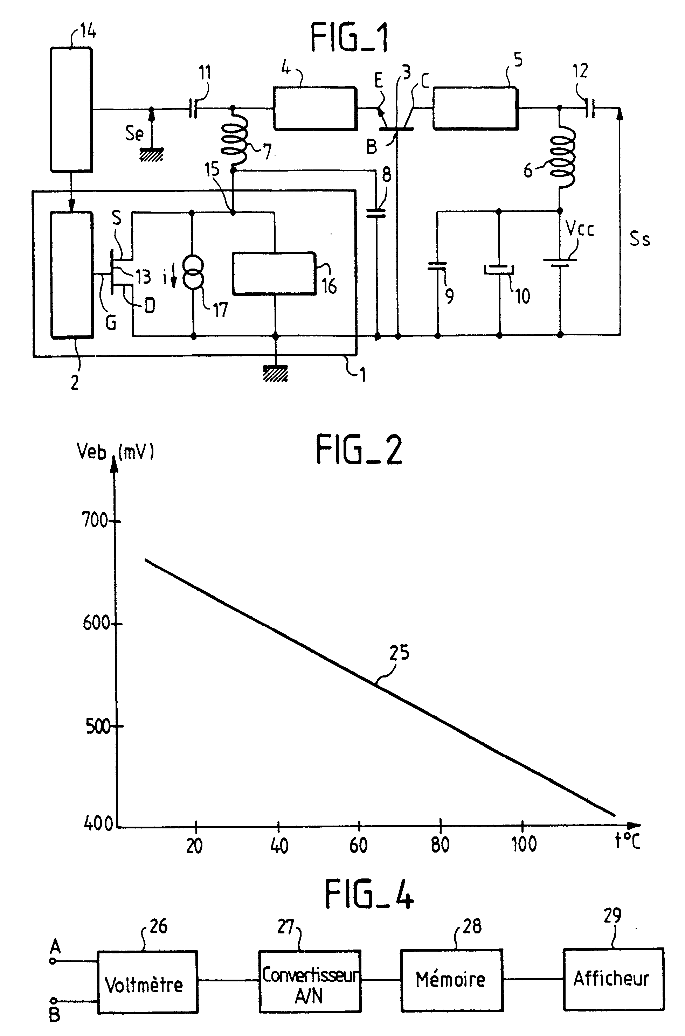

et dont la représentation graphique est donnée par la courbe 25 de la figure 2.

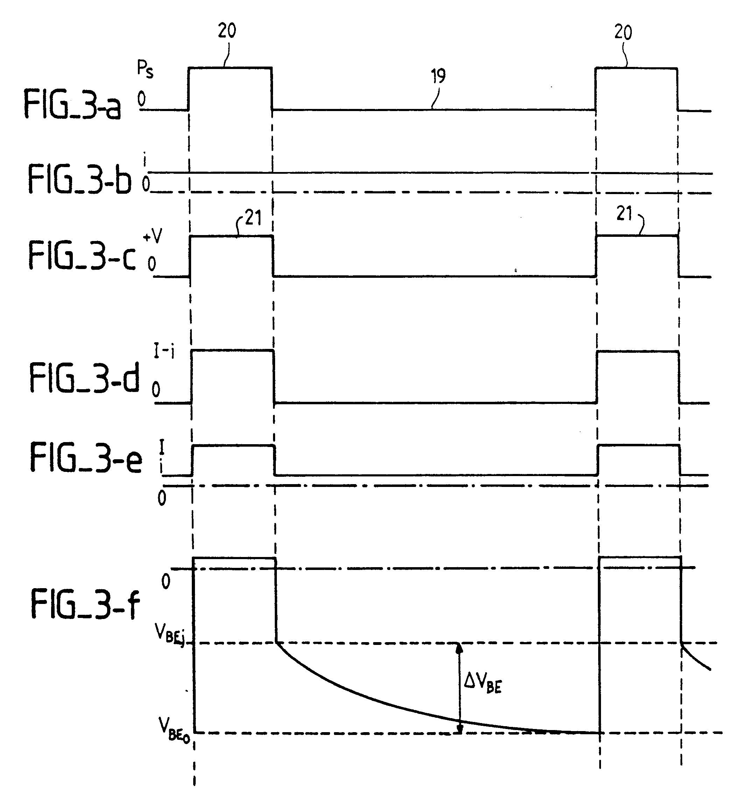

Il faut donc injecter un courant i (figure 3.b) dans la jonction base-émetteur du transistor 3 en dehors des intervalles de temps 20 où le transistor fonctionne en classe C, c'est-à-dire pendant les intervalles de temps 19, et mesurer la variation de la tension émetteur-base Veb due à une diminution de la température. Par contre, pendant le fonctionnement en amplificateur (impulsion 20 - figure 3.a), la variation de la température ne doit être due qu'au courant impulsionnel et il faut donc empêcher le courant i de traverser la jonction base-émetteur du transistor 3. C'est le rôle du transistor FET 13 dont la résistance drain-source Rds est quasi nulle lorsqu'il est conducteur pendant les impulsions 21 (figure 3.c) de tension qui lui sont appliquées sur la grille G et est très élevée lorsqu'il est bloqué par une tension Vg égale au potentiel de la masse.

Ainsi, lorsque le transistor 13 est conducteur (impulsions 21-figure 3.c) le courant Ids qui le traverse est égal à la somme algébrique du courant i du générateur de courant 17 et d'un courant I fourni par le transistor de puissance 3 (figure 3.d). Lorsque le transistor 13 est bloqué, le courant Ids est nul et le courant i traverse la jonction base-émetteur du transistor 3. La figure 3.e montre le diagramme du courant collecteur Ic du transistor 3 qui passe de la valeur i à la valeur I pendant la durée des impulsions 20.

La figure 3.f montre le diagramme de la tension Vbe = V base - V émetteur telle qu'elle apparaît sur l'oscilloscope 16. Cette tension Vbe est légèrement positive pendant la durée des impulsions 20 mais devient négative et égale à $Vbe_j$ dès la fin desdites impulsions. Ensuite, cette tension Vbe continue à décroître au fur et à mesure que la température de la jonction décroît pour atteindre une valeur $Vbe_o$ avant le début de l'impulsion suivante. La tension $Vbe_o$ est significative de la température de la jonction en début d'impulsion et il en résulte que leur différence est significative de la différence de température de la jonction entre la fin d'une impulsion et le début de l'impulsion suivante ou ce qui revient au même, entre le début et la fin d'une même impulsion en régime permanent. La formule (1) permet de déterminer cette différence de température. Pour connaître la température atteinte par la jonction, il suffit de se reporter à la courbe de la tension Veb en fonction de la température t (figure 2).

Le dispositif selon l'invention permet donc de mesurer la température de la jonction d'un transistor en fonctionnement dynamique et cette mesure prend donc en compte les performances dynamiques du transistor tels que le gain, le rendement, la puissance de sortie. Il permet également cette mesure sur les amplificateurs en fonctionnement dans leur équipement en prévoyant des bornes d'accès appropriés pour connecter le dispositif selon l'invention.

Enfin, la mesure effectuée n'est pas destructive car elle ne nécessite pas l'ouverture du capot de protection du transistor bipolaire.

Pour des mesures automatiques de la température de la jonction, l'oscilloscope 16 peut être remplacé par le circuit fonctionnel de la figure 4. Ce circuit comprend par exemple un dispositif de mesure de la tension Veb ou multimètre 26 dont la sortie est connectée à un convertisseur Analogique/Numérique 27 qui transforme la valeur analogique mesurée en un code. Ce code sert de code d'adressage d'une mémoire 28 du type programmable dans laquelle sont enregistrées les données de la courbe 25 de la figure 2. Le code lu dans la mémoire 28 n' est fourni à un circuit d'affichage 29 qu'à un instant précis pendant l'intervalle de temps 19 (figure 3.a). Par décalage de cet instant, on peut ainsi lire la température de la jonction au fur et à mesure de son évolution pendant l'intervalle de temps 19.

Les mesures effectuées par le multimètre 26 sont synchronisées avec les signaux à amplifier de manière à ne tenir compte que des mesures pendant l'intervalle de temps 19.

## Revendications

1. Dispositif de mesure de la température de jonction d'un transistor bipolaire (3) fonctionnant en régime dynamique pulsé, caractérisé en ce qu'il comprend :
- un générateur de courant continu (17) pour fournir un courant i de valeur faible vis-à-vis du courant traversant le transistor bipolaire (3) pendant la durée de l'impulsion à amplifier,
- un circuit de commutation (13) pour aiguiller le courant i vers la jonction base-émetteur du transistor bipolaire (3) en l'absence de ladite impulsion, et
- un circuit de mesure de la variation de tension base-émetteur du transistor (3) en l'absence de ladite impulsion, cette variation de tension étant une liée à la variation de température de la jonction base-émetteur, ce qui permet de connaître la température atteinte par la jonction pendant l'impulsion à amplifier.

2. Dispositif selon la revendication 1, caractérisé en ce que le circuit de commutation (13) est commandé par des signaux synchrones des signaux appliqués au transistor bipolaire (3).

3. Dispositif selon la revendication 2, caractérisé en ce que le circuit de commutation est un transistor à effet de champ (13) connecté entre l'émetteur et la base du transistor bipolaire (3) et dont la grille reçoit les signaux synchrones des signaux appliqués au transistor bipolaire.

4. Dispositif selon la revendication 1, 2 ou 3, caractérisé en ce que le circuit de mesure est un oscilloscope (16) qui est connecté entre l'émetteur et la base du transistor bipolaire (3).

5. Dispositif selon la revendication 1, 2 ou 3, caractérisé en ce que le circuit de mesure est constitué par un dispositif comprenant :
- un multimètre (26) qui est connecté entre l'émetteur et la base du transistor bipolaire (3),
- un convertisseur Analogique/Numérique (27) qui transforme le signal analogique mesuré par le multimètre (26) en un code numérique,
- une mémoire numérique (28) qui contient, sous forme de fichier, la courbe de variation de la tension Vbe en fonction de la température de la jonction, et
- un dispositif d'affichage (29) de la température de la jonction lue dans la mémoire 28.

4

## FIG_1

## FIG_2

Veb (mV)

700

600

500

400

25

20    40    60    80    100    t°C

## FIG_4

A
B

| Voltmètre | Convertisseur A/N | Mémoire | Afficheur |

FIG_3-a

FIG_3-b

FIG_3-c

FIG_3-d

FIG_3-e

FIG_3-f

Office européen
des brevets

RAPPORT DE RECHERCHE EUROPEENNE

Numero de la demande

EP 89 40 0849

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | ELECTRONIQUE APPLICATIONS no. 41, avril/mai 1985, pages 51-56, Paris, France; M. BAIRANZADE et al.:"Mesure automatique du comportement thermique des semi-conducteurs de puissance" * pages 51-53; figure 5 * | 1 | G 01 R 31/26 |
| Y | PATENT ABSTRACTS OF JAPAN vol. 7, no. 38 (P-176)(1183), 16 février 1983; & JP - A - 57 191 574 (NIPPON DENKI) 25-11-1982 | 1 | |
| A | US-A-3 226 642 (G.F. STETZLER) * revendication 1; figure 1 * | 1 | |
| A | DE-B-2 262 053 (IBM) * figure 1 * | 1 | |
| A | DE-B-1 210 086 (SIEMENS-SCHUCKERT AG) * revendication 1; figure 1 * | 1 | |
| | | | **DOMAINES TECHNIQUES RECHERCHES (Int. Cl.4)** |
| | | | G 01 R 31/26 |

**Le présent rapport a été établi pour toutes les revendications**

| Lieu de la recherche | Date d'achèvement de la recherche | Examinateur |
|---|---|---|
| BERLIN | 26-06-1989 | LEMMERICH J |

EPO FORM 1503 03.82 (P0402)